# EUROPEAN PATENT APPLICATION

(11) **EP 4 478 479 A1**
(43) Date of publication of application: **18.12.2024**
(21) Application number: 22956784.7
(22) Date of filing: 30.08.2022
(51) Int. Cl.: H01M 10/48, H01M 50/569

(54) **BATTERY CELL, BATTERY, AND ELECTRICAL DEVICE**

(71) Applicant: Contemporary Amperex Technology (Hong Kong) Limited, Central, Central And Western District (HK)
(72) Inventor: LIN, Denghua, Ningde, Fujian 352100 (CN); CHEN, Long, Ningde, Fujian 352100 (CN); CHEN, Xinxiang, Ningde, Fujian 352100 (CN); ZHENG, Yulian, Ningde, Fujian 352100 (CN); WANG, Peng, Ningde, Fujian 352100 (CN); JIN, Haizu, Ningde, Fujian 352100 (CN)
(74) Representative: Herrmann, Uwe
(86) International application number: PCT/CN2022/115781
(87) International publication number: WO 2024/044951

(57) **Abstract**

The application discloses a battery cell (7), a battery (2) and an electric device. The battery cell (7) includes a housing (20), an electrode assembly (10), a detection assembly (40) and a protective assembly (50). The housing (20) includes an accommodation cavity. The electrode assembly (10) is accommodated in the accommodation cavity. The detection assembly (40) is connected to the housing (20) and is used to detect an operation state of the battery cell (7). The protective assembly (50) protrudes from the housing (20) and is arranged on a same side as the detection assembly (40) so as to protect the detection assembly (40). The embodiments of the application can effectively improve safety and reliability of the battery cell (7).

## Description

### TECHNICAL FIELD

The application relates to the technical field of battery, and in particular to a battery cell, a battery and an electric device.

### BACKGROUND

Battery cells are widely used in electronic equipments such as mobile phones, laptop computers, electric bicycles, electric automobiles, electric aircrafts, electric ships, electric toy cars, electric toy ships, electric toy planes, and electric tools etc. Battery cells may include nickel-cadmium battery cells, nickel-hydrogen battery cells, lithium-ion battery cells, secondary alkaline zinc-manganese battery cells etc.

In development of the battery technology, how to improve stability of the battery cells is a development direction in the battery technology.

### SUMMARY

In view of the above problem, the embodiments of the application provide a battery cell, a battery and an electric device, which can improve safety and reliability of the battery cells.

In a first aspect, the embodiments of the application provide a battery cell. The battery cell includes a housing, an electrode assembly, a detection assembly and a protective assembly. The housing includes an accommodation cavity. The electrode assembly is accommodated in the accommodation cavity. The detection assembly is connected to the housing and is used to detect an operation state of the battery cell. The protective assembly protrudes from the housing and is arranged on a same side as the detection assembly so as to protect the detection assembly.

In the aforesaid technical solution, by providing a detection assembly on the battery cell, it is convenient to control the operation state of the battery cell in real time. Abnormal parameters during operation of the battery cell can be quickly warned, enabling corresponding safety agencies or personnel to respond in a timely manner, thereby improving safety and reliability of the battery cell. By providing the protective assembly for protecting the detection assembly, a risk of damage to the detection assembly during the use of the battery cell can be reduced.

In some embodiments of the first aspect, the housing includes a first wall, and the detection assembly is connected to the first wall.

In some embodiments of the first aspect, the detection assembly is located on a side of the first wall away from the accommodation cavity.

In the aforesaid technical solution, it is possible to reduce the occupation of internal space of the battery cell by the detection assembly and the protective assembly; at the same time, it also facilitates the installation and replacement of the detection assembly and the protective assembly.

In some embodiments of the first aspect, the housing includes an electrode terminal, the electrode terminal protrudes from a side surface of the first wall away from the accommodation cavity, the electrode terminal is electrically connected to an electrode tab of the electrode assembly, and the detection assembly is electrically connected to the electrode terminal and forms a connection portion on the electrode terminal.

In some embodiments of the first aspect, the protective assembly includes a first protective member, the first protective member protrudes from a side surface of the electrode terminal away from the first wall, and the first protective member is used to separate the side surface of the electrode terminal away from the first wall from the connection portion.

In the aforesaid technical solution, by providing the first protective member on the side surface of the electrode terminal away from the first wall, and separating the connection portion from a central region of the side surface of the electrode terminal away from the first wall, it is possible to reduce a risk of damage to the detection assembly during formation process of the battery cell.

In some embodiments of the first aspect, the first protective member is distributed in an annular segment or in an annular shape in a circumferential direction of the electrode terminal.

In the aforesaid technical solution, by providing the first protective member as a structure distributed in an annular segment in the circumferential direction of the electrode terminal, it is possible to provide more targeted protection for the connection portion. The use of fewer materials can achieve protection of the detection assembly, and effectively reduce costs. By providing the first protective member as a structure distributed in an annular shape in the circumferential direction of the electrode terminal, it is possible to make the central region of the electrode terminal completely surrounded and spaced, maximizing the protection range of the first protective member and effectively improving the protection effect of the first protective member on the detection assembly.

In some embodiments of the first aspect, the first protective member includes a body portion and an avoidance portion, and the avoidance portion is formed by the body portion being recessed towards a center point of the electrode terminal so as to avoid the connection portion.

In the aforesaid technical solution, by adjusting the avoidance portion of the first protective member, not only can the body portion of the first protective member be arranged closer to the edge of the electrode terminal, but it can also effectively reduce the influence of the first protective member on the insertion of the formation pin into the electrode terminal. It can also make the protective region formed by the first protective member close to the connection portion larger, further enhancing the protective effect of the first protective member on the detection assembly.

In some embodiments of the first aspect, in a thickness direction of the first wall, the first protective member has a size h1, the connection portion has a size h2, and h1>h2.

In the aforesaid technical solution, in the thickness direction of the first wall, the arrangement where the size h1 of the first protective member is greater than the size h2 of the connection portion can fully separate the central region of the connection portion and the electrode terminal by the first protective member. During the formation process of the battery cell, it is possible to reduce the risk of damage to the connection portion caused by contact with the connection portion due to deviation in the insertion of the formation pin. The protective effect of the first protective member on the detection assembly is further enhanced.

In some embodiments of the first aspect, h1 and h2 satisfy a relationship of: h1-h2 ≥ 1mm.

In the aforesaid technical solution, by providing the relationship between the size h1 of the first protective member and the size h2 of the connection portion in the thickness direction of the first wall within the above range, it is possible to further improve the protective effect of the first protective member.

In some embodiments of the first aspect, the first protective member has a wall thickness d1 ≥ 0.5mm.

In the aforesaid technical solution, by providing the wall thickness d1 of the first protective member within the above range, it is possible to further improve the protective effect of the first protective member.

In some embodiments of the first aspect, the battery cell further includes an insulation member for insulating the electrode terminal from the first wall; the insulation member has a protrusion protruding from the side surface of the electrode terminal away from the first wall, and the protrusion is configured as the first protective member.

In some embodiments of the first aspect, the protrusion and the insulation member are of an integrally formed structure.

In the aforesaid technical solution, by providing a protrusion on the insulation member to serve as the first protective member, the insulation member is integrally formed into a protrusion through stamping technology, resulting in an integrated structure between the protrusion and the insulation member. On the one hand, it is convenient to apply the protrusion of the embodiment to the design of the existing insulation member, without the need for excessive modifications to the design of the existing insulation member; on the other hand, the insulation member forms a protrusion through stamping technology, which is simple to manufacture and does not require additional materials to form the protrusion.

In some embodiments of the first aspect, the insulation member is provided with a through hole, and the detection assembly is connected to the electrode terminal through the through hole.

In the aforesaid technical solution, the detection assembly is connected to the electrode terminal located inside the insulation member through the through hole, and the connection portion between the detection assembly and the electrode terminal is located inside the insulation member, reducing the risk of damage to the connection portion between the detection member and the electrode terminal due to exposure to the external environment.

In some embodiments of the first aspect, the first wall is provided with a liquid injection hole, the protective assembly includes a second protective member, and the second protective member protrudes from a side surface of the first wall away from the accommodation cavity and surrounds the liquid injection hole.

In the aforesaid technical solution, by providing the second protective member around the liquid injection hole, the risk of the electrolyte solution overflow causing damage to the detection assembly can be reduced, further improving the protective effect of the protection assembly.

In some embodiments of the first aspect, in the thickness direction of the first wall, the second protective member has a size h3 ≥ 1mm.

In the aforesaid technical solution, by providing the size h3 of the second protective member within the above range, it is possible to further improve the protective effect of the second protective member.

In some embodiments of the first aspect, the second protective member includes a blocking portion and an adsorption portion, and the adsorption portion is arranged on a side of the blocking portion away from the liquid injection hole.

In the aforesaid technical solution, the second protective member includes a blocking portion and an adsorption portion located on the side of the blocking portion away from the injection hole. While the blocking portion can reduce electrolyte solution overflow, the adsorption portion can further adsorb the electrolyte solution splashed out in a few cases, further enhancing the protective effect of the second protective member.

In some embodiments of the first aspect, the adsorption portion is distributed surrounding the blocking portion in a circumferential direction.

In the aforesaid technical solution, the adsorption portion is distributed in an annular segment in the circumferential direction of the blocking portion, allowing for the adsorption of electrolyte solution splashed out in a few cases with minimal use of materials, effectively reducing costs. The adsorption portion is distributed in an annular shape in the circumferential direction of the blocking portion, and is arranged around the entire circumference of the blocking portion, which can increase the adsorption range of the adsorption portion and effectively improve the adsorption effect of the adsorption portion.

In some embodiments of the first aspect, the second protective member and the first wall are of an integrally formed structure.

In the aforesaid technical solution, on the one hand, there is no need to make significant changes to the design of the housing of the existing battery cell; on the other hand, the first wall forms a second protective member through stamping technology, which is simple in production process and does not require additional materials to form a second protective member.

In some embodiments of the first aspect, the housing includes a housing body and an end cap, the housing body has an opening, and the end cap is used to cap the opening. The end cap is configured as the first wall of the housing.

In some embodiments of the first aspect, the material of the protective assembly is an insulation-heat barrier material.

In the aforesaid technical solution, by using an insulation-heat barrier material to produce the protective assembly, the impact of heat generated by the battery cell during use on the protective assembly can be reduced, and the service life of the protective assembly can be improved. At the same time, it can avoid interference between the protective assembly and the detection assembly, which will affect the normal use of the detection assembly.

In some embodiments of the first aspect, the detection assembly includes a sensing member and a connector connected to each other, and the connector is used to transmit an electrical signal to the sensing member.

In some embodiments of the first aspect, the connector includes an optical fiber, which can improve transmission speed of the signals.

In a second aspect, the embodiments of the application provide a battery including the battery cell provided by any embodiment of the first aspect.

In a third aspect, the embodiments of the application provide an electric device including the battery cell provided by any embodiment of the first aspect used to provide electrical energy.

The above description is only an overview of the technical solution of the application, which, in order to understand the technical means of the application more clearly, can be implemented according to the content of the description, and for better understanding of the above and other objects, features and advantages of the application, the detailed embodiments of the application will be set forth below.

### BRIEF DESCRIPTION OF THE DRAWINGS

By reading the detailed description of the preferable embodiments in the following, the various other advantages and benefits will become clear to a person of ordinary skill in the art. The accompanying drawings are merely intended for the purpose of illustrating preferable embodiments and are not deemed as a limitation on the application. And in all the drawings, the same reference number is used to indicate the same component. In the drawings:
Fig. 1 is a schematic structural view of a vehicle provided by some embodiments of the application;
Fig. 2 is a schematic explosive view of a battery provided by some embodiments of the application;
Fig. 3 is a schematic structural view of the battery module as shown in Fig. 2;
Fig. 4 is a schematic explosive view of a battery cell provided by some embodiments of the application;
Fig. 5 is a schematic structural view of a first wall of a battery cell provided by some embodiments of the application;
Fig. 6 is a schematic structural partial enlarged view at an electrode terminal of a battery cell provided by some embodiments of the application;
Fig. 7 is a schematic structural partial enlarged view at an electrode terminal of another battery cell provided by some embodiments of the application;
Fig. 8 is a schematic structural partial enlarged view at an electrode terminal of yet another battery cell provided by some embodiments of the application;
Fig. 9 is a schematic structural partial enlarged view at an electrode terminal of still yet another battery cell provided by some embodiments of the application;
Fig. 10 is a schematic structural partial enlarged view at an electrode terminal of still yet another battery cell provided by some embodiments of the application;
Fig. 11 is a schematic structural view of a first wall of another battery cell provided by some embodiments of the application;
Fig. 12 is a schematic structural partial enlarged view at an insulation member of a battery cell provided by some embodiments of the application;
Fig. 13 is a schematic structural view of a first wall of yet another battery cell provided by some embodiments of the application;
Fig. 14 is a schematic structural partial enlarged view at a second protective member of a battery cell provided by some embodiments of the application;
Fig. 15 is a schematic structural view of a first wall of still yet another battery cell provided by some embodiments of the application;
Fig. 16 is a schematic structural view of a first wall of still yet another battery cell provided by some embodiments of the application;

The reference numbers in the detailed embodiments are as follows:
1, vehicle; 2, battery; 3, controller; 4, motor; 5, case; 5a, first case portion; 5b, second case portion; 5c, accommodation space; 6, battery module; 7, battery cell; 10, electrode assembly; 20, housing; 30, first wall; 31, electrode terminal; 32, insulation member; 321, through hole; 33, liquid injection hole; 40, detection assembly; 41, connection portion; 42, sensing member; 43, connector; 50, protective assembly; 51, first protective member; 51a, body portion; 51b, avoidance portion; 52, second protective member; 52a, blocking portion; 52b, adsorption portion.

### DETAILED DESCRIPTION

The embodiments for the technical solution of the application will be described in detail below in combination with the drawings. The following embodiments are only intended to provide a clearer explanation of the technical solution of the application, and thus are only used as examples and cannot be used to limit the protection scope of the application.

In order to make the purpose, the solution and the advantages of the embodiments of the application clearer, the technical solution of the embodiments of the application will be described clearly and completely below with reference to the accompanying drawings. It is obvious that the embodiments as described are only a part of the embodiments of the application, rather than all of the embodiments. Based on the embodiments of the application, all other embodiments obtained by a person of ordinary skill in the art without creative efforts shall fall within the protection scope of the application.

Unless otherwise defined, all the technical and scientific terms used in the application have the same meanings as commonly understood by a person skilled in the art of the application. The terms used in the description of this application is for the purpose of describing specific embodiments only and is not intended to limit the application. The terms "comprise", "have" and any variations thereof in the description and claims of the application and the brief description of the drawings above are intended to cover non-exclusive inclusions. The terms "first", "second" and the like in the description and claims of the application or in the aforesaid drawings are used to distinguish different objects and are not used to describe a particular order or primary-secondary relationship.

Reference to "embodiment" in the application means that the specific features, structures, or characteristics described in connection with the embodiment may be included in at least one embodiment of the application. The presence of this phrase at various locations in the description does not necessarily refer to the same embodiment, nor is it a separate or alternative embodiment that is mutually exclusive from other embodiments.

In the description of the application, it is noted that, except as otherwise stipulated or limited explicitly, the terms "mount", "link", "connect", "attach" shall be interpreted expansively, for example, it may be fixed connection, removable connection or integral connection; may be direct connection or indirect connection via an intermediate medium, or may be communication inside two elements. For a person of ordinary skill in the art, the specific meaning of the above terms in the application can be interpreted depending on the specific situation.

In the application, the term "and/or" is merely to describe an association relationship of associated objects, meaning that there may be three relationship, for example, A and/or B may mean three cases that A exists alone, A and B exist simultaneously, and B exists alone. In addition, the character "/" in the application generally indicates that the related objects before and after have an "or" relationship.

In the embodiments of the application, the same reference numerals denote the same components, and in the different embodiments, detailed description of the same components is omitted for brevity. It should be understood that the thickness, length, width, and the like of the various components, and the overall thickness, length, width, and the like of the integrated device in the embodiments of the application shown in the drawings are merely illustrative and should not be construed as limiting of the application.

Reference to "a plurality of" in the application means two or more (including two).

In the application, the term "parallel" includes not only the case of being absolutely parallel, but also the case of being approximately parallel as conventionally understood in engineering; at the same time, "vertical" also includes not only the case of being absolutely vertical, but also the case of being approximately vertical as conventionally understood in engineering.

At present, from the development of the market situation, the application of power batteries is becoming increasingly widespread. The power batteries are not only used in energy storage power systems such as hydropower, firepower, wind power, and solar power stations, but also widely used in electric vehicles such as electric bicycles, electric motorcycles, and electric automobile, as well as multiple fields such as military equipment and aerospace. With the continuous expansion of the application field of power batteries, their market demand is also constantly expanding.

In the application, the battery cell may include a lithium ion secondary battery cell, a lithium ion primary battery cell, a lithium sulfur battery cell, a sodium lithium ion battery cell, a sodium ion battery cell, a magnesium ion battery cell, or the like, which is not limited by the embodiments of the application. The battery cell may be in the form of a cylinder, a flat body, a cuboid, or other shape, which is not limited by the embodiments of the application.

The battery mentioned in the embodiments of the application refers to a single physical module including one or more battery cells to provide higher voltage and capacity. For example, the battery mentioned in the application may include a battery module or a battery pack or the like. The battery generally includes a case for packaging one or more battery cells. The case can prevent liquid or other foreign matter from affecting the charging or discharging of the battery cell.

The battery cell includes an electrode assembly and electrolyte solution, and the electrode assembly is composed of a positive electrode sheet, a negative electrode sheet and a separator membrane. The battery cell operates mainly by moving metal ions between the positive and negative electrode sheets. The positive electrode sheet includes a positive electrode current collector and a positive electrode active material layer coated on a surface of the positive electrode current collector. The electrode current collector which is not coated with the positive electrode active material layer protrudes from the electrode current collector which is coated with the positive electrode active material layer. The electrode current collectors which are not coated with the positive electrode active material layers are stacked and then serve as a positive electrode tab. Taking a lithium ion battery as an example, the material of the positive electrode current collector may be aluminum, and the positive electrode active material may be lithium cobaltate, lithium iron phosphate, lithium ternary or lithium manganate or the like. The negative electrode sheet includes a negative electrode current collector and a negative electrode active material layer coated on a surface of the negative electrode current collector. The electrode current collector which is not coated with the negative electrode active material layer protrudes from the electrode current collector which is coated with the negative electrode active material layer. The electrode current collectors which are not coated with the negative electrode active material layers are stacked and then serve as a negative electrode tab. The material of the negative electrode current collector may be copper, and the negative electrode active material may be carbon, silicon or the like. The material of the separator membrane may be PP, PE and the like. In addition, the electrode assembly may be of a wound structure or a laminated structure, which is not limited by the embodiments of the application.

The battery cell further includes a housing, and the housing includes a housing body, an end cap, an electrode terminal, an insulation member and a liquid injection hole. The housing body has an opening, and the end cap is capped and sealingly connected to the opening so as to form a sealed space for accommodating the electrode assembly and the electrolyte solution After the end cap is connected to the housing body, the electrolyte solution can be injected into the battery cell through the liquid injection hole in the end cap. The insulation member encircles the electrode terminal to prevent a short circuit at the electrode terminal.

The inventor of this application notes that currently, none of the existing battery cells are provided with a detection assembly, making it impossible to perform a real-time detection of the operation state of the battery cell. Among them, the operation state of the battery cell includes, but is not limited to, relevant data such as voltage and temperature. At the same time, the existing battery cells are not provided with a protective assembly for the detection assembly.

In order to solve the problem of impossible real-time detection of the operation state of the battery cell, the inventor of the application has found that the real-time detection of the operation state of the battery cell can be achieved by providing a detection assembly. The detection assembly can control the operation state of the battery cell in real time, provide an early warning of abnormal parameters during operation of the battery cell, enabling corresponding safety agencies or personnel to respond in a timely manner, thereby improving safety and reliability of the battery cell. At the same time, by providing the protective assembly for protecting the detection assembly, a risk of damage to the detection assembly during the use of the battery cell can be reduced.

Based on the above considerations, the inventor has conducted in-depth research and designed a battery cell. By providing a detection assembly and a protective assembly for protecting the detection assembly on the battery cell, it is possible to control the operation state of the battery cell in real time, while also reducing a risk of damage to the detection assembly during the use of the battery cell.

The technical solutions described in the embodiments of the application are applicable to battery cells, batteries and electric devices employing batteries.

The electric device may be a vehicle, a mobile phone, a portable device, a notebook computer, a ship, a spacecraft, an electric toy and a power tool, etc. The vehicle may be a fuel, gas or new energy vehicle. The new energy vehicle may be a pure electric vehicle, a hybrid vehicle, an extended-range vehicle, etc. The spacecraft includes an airplane, a rocket, an aerospaceplane, a spaceship, etc. The electric toy includes a fixed or movable electric toy, for example, a game machine, an electric car toy, an electric ship toy, and an electric airplane toy, etc. The power tool includes a metal cutting power tool, a grinding power tool, an assembly power tool, and a railway power tool, for example, an electric drill, an electric grinder, an electric wrench, an electric screwdriver, an electric hammer, an impact electric drill, a concrete vibrator and an electric planer, etc. The embodiments of the application have no particular limitation to the above electric device.

It is to be understood that the technical solution described by the embodiments of the application is not limited to the batteries and electric devices described above, but is also applicable for all the batteries including a case and the electric devices employing the batteries. However, for the sake of simplicity, the following embodiments are all illustrated using an electric automobile as an example.

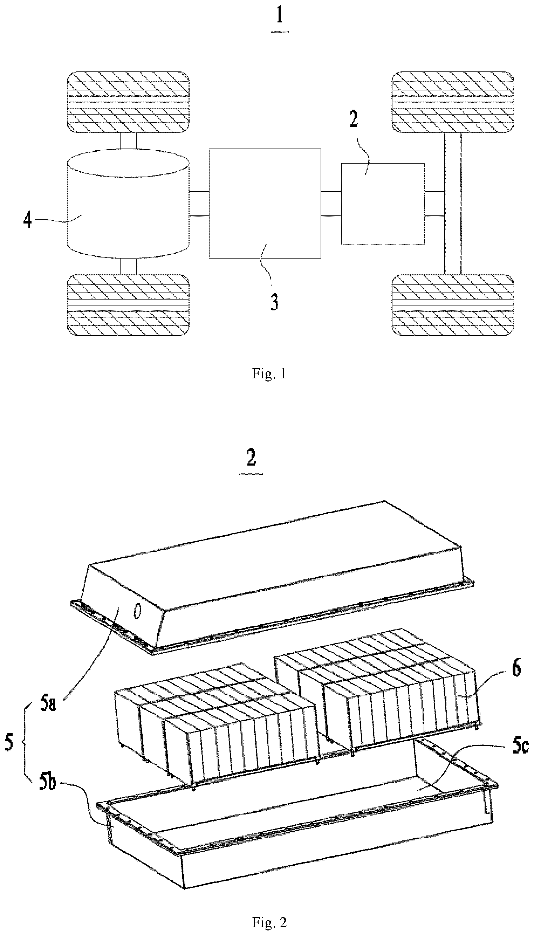

Fig. 1 is a schematic structural view of a vehicle provided by some embodiments of the application.

As shown in Fig. 1, a battery 2 is provided inside the vehicle 1, and the battery 2 may be disposed at a bottom or a head or a rear of the vehicle 1. The battery 2 may be used for powering the vehicle 1. For example, the battery 2 may serve as an operational power source for the vehicle 1.

The vehicle 1 may also include a controller 3 and a motor 4. A controller 3 is used for controlling the battery 2 to power the motor 4, for example, for operational power requirements during start-up, navigation and traveling of the vehicle 1.

In some embodiments of the application, the battery 2 may serve not only as an operational power source for the vehicle 1, but also as a drive power source for the vehicle 1 to provide a drive power for the vehicle 1 instead of or partially instead of fuel or natural gas.

Fig. 2 is a schematic explosive view of a battery provided by some embodiments of the application.

As shown in Fig. 2, the battery 2 includes a case 5 and a battery cell, and the battery cell is accommodated in the case 5.

The case 5 is used for accommodating the battery cell, and the case 5 may have various structures. In some embodiments, the case 5 may include a first case portion 5a and a second case portion 5b capped by each other. The first case portion 5a and the second case portion 5b together define an accommodation space 5c for accommodating the battery cell. The second case portion 5b may be of a hollow structure with one end open, the first case portion 5a is of a plate-like structure, and the first case portion 5a is capped to the open side of the second case portion 5b to form the case 5 with the accommodation space 5c. Also, each of the first case portion 5a and the second case portion 5b may be of a hollow structure with one side open, and the open side of the first case portion 5a is capped to the open side of the second case portion 5b to form the case 5 with the accommodation space 5c. Of course, the first case portion 5a and the second case portion 5b may have various shapes, such as a cylinder, a cuboid and the like.

In order to increase the seal property after the first case portion 5a and the second case portion 5b are connected, a seal member, such as seal glue or a seal ring, may be provided between the first case portion 5a and the second case portion 5b.

If the first case portion 5a is capped on the top of the second case portion 5b, the first case portion 5a may also be referred to as an upper case cover, and the second case portion 5b may also be referred to as a lower case body.

In the battery 2, the amount of battery cell may be single or plural. If there are a plurality of battery cells, the plurality of battery cells may be connected in series or in parallel or in a mixed manner, wherein the mixed manner means that the plurality of battery cells are connected both in series and in parallel. The plurality of battery cells may be directly connected together in series or in parallel or in the mixed manner, and the entirety constituted by the plurality of battery cells is accommodated in the case 5. Of course, the plurality of battery cells may also be connected in series or in parallel or in the mixed manner to form battery modules 6 at first, and then a plurality of battery modules 6 may be connected in series or in parallel or in the mixed manner to form an entirety and be accommodated in the case 5.

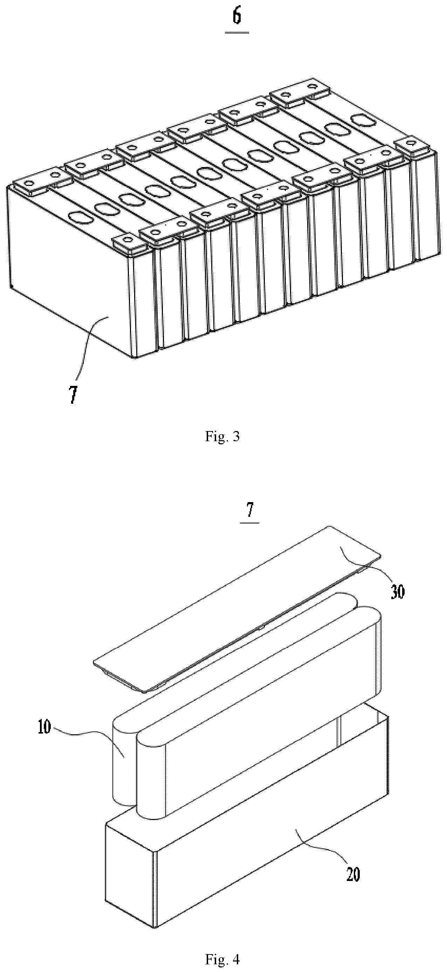

Fig. 3 is a schematic structural view of the battery module as shown in Fig. 2.

In some embodiments, as shown in Fig. 3, there are a plurality of battery cells 7, and the plurality of battery cells 7 are connected in series or in parallel or in the mixed manner to form battery modules 6 at first. Then a plurality of battery modules 6 are connected in series or in parallel or in the mixed manner to form an entirety and are accommodated in the case.

The plurality of battery cells 7 in a battery module 6 may be electrically connected by a bus member to achieve a parallel or series or mixed connection of the plurality of battery cells 7 in the battery module 6.

Fig. 4 is a schematic explosive view of a battery cell provided by some embodiments of the application.

As shown in Fig. 4, the battery cell 7 provided by the embodiments of the application includes an electrode assembly 10 and a housing 20, and the electrode assembly 10 is accommodated in the housing 20. The housing 20 may also be used to accommodate electrolyte, such as electrolyte solution.

In some embodiments, the housing 20 includes a first wall 30, and the housing 20 may have various shapes such as a cylinder, a cuboid or the like. The shape of the housing 20 may be determined according to a specific shape of the electrode assembly 10. For example, if the electrode assembly 10 is of a cylindrical structure, the housing may be selected to be cylindrical, and if the electrode assembly 10 is of a cuboid structure, the housing may be selected to be cuboid.

In the battery cell 7, the amount of electrode assembly 10 accommodated in the housing 20 may be single, two or plural. For example, in Fig. 4, the amount of electrode assembly 10 is two.

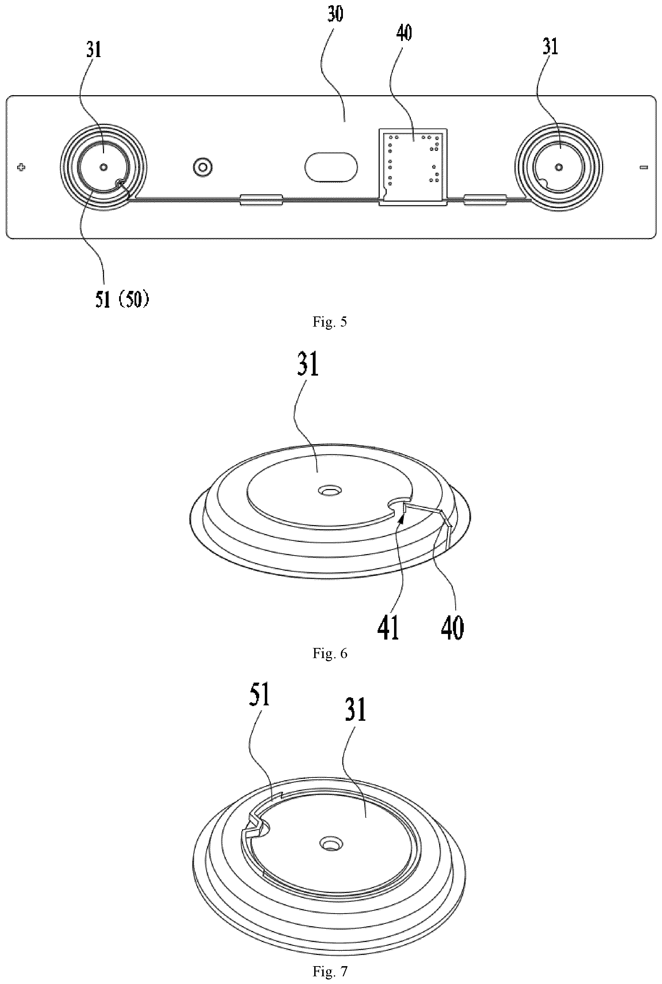

Fig. 5 is a schematic structural view of a first wall of a battery cell provided by some embodiments of the application, and Fig. 6 is a schematic structural partial enlarged view at an electrode terminal of a battery cell provided by some embodiments of the application.

As shown in Figs. 4 to 6, the embodiments of the application provide a battery cell 7 including a housing 20, an electrode assembly 10, a detection assembly 40, and a protective assembly 50. The housing 20 has an accommodation cavity. The electrode assembly 10 is accommodated in the accommodation cavity. The detection assembly 40 is connected to the housing 20 and is used to detect an operation state of the battery cell 7. The protective assembly 50 protrudes from the housing 20 and is arranged on a same side as the detection assembly 40 so as to protect the detection assembly 40.

Optionally, the detection assembly 40 may be arranged on a side of the housing 20 away from the accommodation cavity, or may also be arranged on a side of the housing 20 facing towards the accommodation cavity. By arranging the detection assembly 40 on the side of the housing 20 away from the accommodation cavity, it is possible to reduce the occupation of internal space of the battery cell 7 by the detection assembly 40; by arranging the detection assembly 40 on the side of the housing 20 facing towards the accommodation cavity, it is possible to reduce the overall volume of the battery cell 7. The detection assembly 40 can perform a real-time detection of the operation state of the battery cell 7, where the operation state of the battery cell 7 includes, but is not limited to, voltage, temperature, and other related data. By providing a detection assembly 40 on the battery cell 7, it is convenient to control the operation state of the battery cell 7 in real time. Abnormal parameters during operation of the battery cell 7 can be quickly warned, enabling corresponding safety agencies or personnel to respond in a timely manner, thereby improving safety and reliability of the battery cell 7.

In some embodiments, the housing 20 includes a first wall 30, and the detection assembly 40 is connected to the first wall 30. Among them, the first wall 30 may be any wall forming the housing 20 of the battery cell 7, and the connection type between the detection assembly 40 and the first wall 30 may be, but is not limited to, welding, clamping, or adhering.

The protective assembly 50 is used to protect the detection assembly 40, so that a risk of damage to the detection assembly 40 during the use of the battery cell 7 can be reduced.

In the embodiments of the application, the inventive concept is illustrated taking that the detection assembly 40 is arranged on the side of the first wall 30 away from the accommodation cavity as an example. The protective assembly 50 is arranged on the same side as the detection assembly 40, that is, the protective assembly 50 is also arranged on the side surface of the end cap away from the electrode assembly. The protective assembly 50 protrudes from the housing 20, that is, in the thickness direction of the first wall 30, the protective assembly 50 is formed by protruding from the side surface of the first wall 30 away from the accommodation cavity. In this way, it is possible to reduce the occupation of internal space of the battery cell 7 by the detection assembly 40 and the protective assembly 50; at the same time, it also facilitates the installation and replacement of the detection assembly 40 and the protective assembly 50.

By providing the protective assembly 50 for protecting the detection assembly 40 50, a risk of damage to the detection assembly 40 during the use of the battery cell 7 can be reduced.

In some embodiments, the housing 20 includes an electrode terminal 31. The electrode terminal 31 protrudes from one side surface of the first wall 30 away from the accommodation cavity. The electrode terminal 31 is electrically connected to the electrode tab of the electrode assembly 10, and the detection assembly 40 is electrically connected to the electrode terminal 31 and forms a connection portion 41 on the electrode terminal 31.

In the embodiments of the application, the connection type between the electrode terminal 31 and the first wall 30 may be, but is not limited to, welding, riveting, or adhering. The connection type between the detection assembly 40 and the first wall 30 may be, but is not limited to, welding, clamping, or adhering. The detection assembly 40 is electrically connected to the electrode terminal 31, and can detect relevant data such as voltage and temperature at the electrode terminal 31 of the battery cell 7, facilitating real-time control of the operation state of the battery cell 7, providing an early warning of abnormal parameters during operation of the battery cell 7, enabling corresponding safety agencies or personnel to respond in a timely manner, thereby improving safety and reliability of the battery cell 7.

In the embodiments of the application, the inventive concept is illustrated taking that the detection assembly 40 is arranged on the side of the first wall 30 away from the accommodation cavity as an example. The electrode terminal 31 protrudes from the side surface of the first wall 30 away from the accommodation cavity, and the portion of the electrode terminal 31 protruding from the side surface of the first wall 30 away from the accommodation cavity is located on the same side of the first wall 30 as the detection assembly 40, facilitating electrical connection between the detection assembly 40 and the electrode terminal 31 and forming a connection portion 41 on the electrode terminal 31. Among them, the connection portion 41 is the connection between the electrode terminal 31 and the detection assembly 40.

In some embodiments, the protective assembly 50 includes a first protective member 51, the first protective member 51 protrudes from the side surface of the electrode terminal 31 away from the first wall 30, and the first protective member 51 is used to separate the side surface of the electrode terminal 31 away from the first wall 30 from the connection portion 41.

Since the battery unit 7 has no electricity when accomplishing assembly, it needs to be charged and activated. The process of first charging the battery cell 7 is referred to as formation, which is used to activate the active material inside the battery cell 7. During the formation process of the battery cell 7, the formation pin will be inserted into the central region of the electrode terminal 31 for formation operation. During this process, if insertion of the formation pin deviates, it is easy to accidentally touch the detection assembly 40, thereby resulting in damage to the detection assembly 40.

For example, in the embodiments of the application, the inventive concept is illustrated taking that the detection assembly 40 is arranged on the side of the first wall 30 away from the accommodation cavity as an example. The electrode terminal 31 protrudes from the side surface of the first wall 30 away from the accommodation cavity, and the portion of the electrode terminal 31 protruding from the side surface of the first wall 30 away from the accommodation cavity is located on the same side of the first wall 30 as the detection assembly 40, facilitating electrical connection between the detection assembly 40 and the electrode terminal 31 and forming a connection portion 41 on the electrode terminal 31. Among them, the connection portion 41 is the connection between the electrode terminal 31 and the detection assembly 40.

The first protective member 51 is arranged to protrude from the side surface of the electrode terminal 31 away from the end cap, and the first protective member 51 separates the connection portion 41 from the central region of the side surface of the electrode terminal 31 away from the first wall 30.

By providing the first protective member 51 on the side surface of the electrode terminal 31 away from the first wall 30, and separating the connection portion 41 from a central region of the side surface of the electrode terminal 31 away from the first wall 30, it is possible to reduce a risk of damage to the detection assembly 40 during formation process of the battery cell 7.

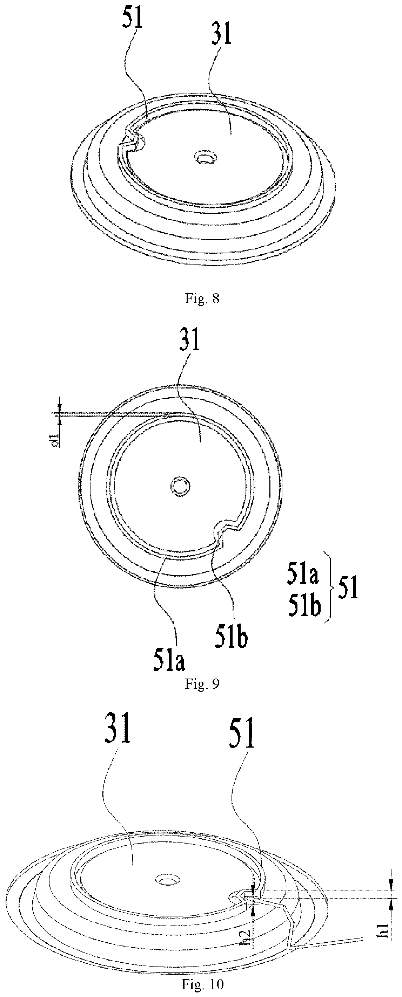

Fig. 7 is a schematic structural partial enlarged view at an electrode terminal of another battery cell provided by some embodiments of the application, and Fig. 8 is a schematic structural partial enlarged view at an electrode terminal of yet another battery cell provided by some embodiments of the application.

As shown in Figs. 5 to 8, in some embodiments, the first protective member 51 is distributed in an annular segment or in an annular shape in a circumferential direction of the electrode terminal 31.

The first protective member 51 is distributed in an annular segment in the circumferential direction of the electrode terminal 31, and a protective wall is formed at the annular segment. The protective wall separates the side surface of the electrode terminal 31 away from the first wall 30 from the connection portion 41. By providing the first protective member 51 as a structure distributed in the annular segment in the circumferential direction of the electrode terminal 31, it is possible to provide more targeted protection for the connection portion 41. It is possible to achieve protection of the detection assembly 40 with fewer materials, effectively reducing costs.

By providing the first protective member 51 as a structure distributed in an annular segment in the circumferential direction of the electrode terminal 31, a complete protective wall is formed around the electrode terminal 31, which can make the central region of the electrode terminal 31 completely surrounded and spaced, maximizing the protection range of the first protective member 51 and effectively improving the protection effect of the first protective member 51 on the detection assembly 40.

Fig. 9 is a schematic structural partial enlarged view at an electrode terminal of still yet another battery cell provided by some embodiments of the application.

As shown in Figs. 5 to 9, in some embodiments, the first protective member 51 includes a body portion 51a and an avoidance portion 51b. The avoidance portion 51b is formed by the body portion 51a being recessed towards the center point of the electrode terminal 31 to avoid the connection portion 41.

Specifically, the body portion 51a of the first protective member 51 is in an annular segment or in an annular structure in the circumferential of the electrode terminal 31. The avoidance portion 51b of the first protective member 51 is arranged corresponding to the connection portion 41. The avoidance portion 51b of the first protective member 51 is used to avoid the connection portion 41, so that the body portion 51a of the first protective member 51 can be arranged closer to the edge of the electrode terminal 31. The closer the body portion 51a of the first protective member 51 is to the edge of the electrode terminal 31, the larger the area left for the central region of the electrode terminal 31 to be inserted into by the formation pin is, which can effectively reduce the impact of the first protective member 51 on the insertion of the formation pin into the electrode terminal 31. At the same time, since the avoidance portion 51b is formed by the body portion 51a being recessed towards the center point of the electrode terminal 31, in the direction from the edge of the electrode terminal 31 to the center point of the electrode terminal 31, the protective region formed by the first protective member 51 close to the connection portion 41 is larger, which can further strengthen the protective effect of the first protective member 51 on the detection assembly 40.

By adjusting the avoidance portion 51b of the first protective member 51, not only can the body portion 51a of the first protective member 51 be arranged closer to the edge of the electrode terminal 31, but it can also effectively reduce the influence of the first protective member 51 on the insertion of the formation pin into the electrode terminal 31. It can also make the protective region formed by the first protective member 51 close to the connection portion 41 larger, further enhancing the protective effect of the first protective member 51 on the detection assembly 40.

Fig. 10 is a schematic structural partial enlarged view at an electrode terminal of still yet another battery cell provided by some embodiments of the application.

As shown in Figs. 5 to 10, in some embodiments, in the thickness direction of the first wall 30, the first protective member 51 has a size h1, the connection portion 41 has a size h2, and h1>h2.

As set forth above, the first protective member 51 protrudes from the side surface of the electrode terminal 31 away from the end cap as so to separate the connection portion 41 from the central region of the electrode terminal 31. In the thickness direction of the first wall 30, the size h1 of the first protective member 51 is the protrusion height of the first protective member 51; the size h2 of the connection portion 41 is the protrusion height of the connection portion 41 from the side surface of the electrode terminal 31 away from the first wall 30. In the thickness direction of the first wall 30, if the size h1 of the first protective member 51 is smaller than the size h2 of the connection portion 41, there is a risk of the connection portion 41 being damaged by the formation pin during the formation process of the battery cell 7.

In this way, in the thickness direction of the first wall 30, the arrangement where the size h1 of the first protective member 51 is greater than the size h2 of the connection portion 41 can fully separate the central region of the connection portion 41 and the electrode terminal 31 by the first protective member 51. During the formation process of the battery cell 7, it is possible to reduce the risk of damage to the connection portion 41 caused by contact with the connection portion 41 due to deviation in the insertion of the formation pin. The protective effect of the first protective member 51 on the detection assembly 40 is further enhanced.

In some embodiments, h1 and h2 satisfy a relationship of: h1-h2≥1mm.

In the aforesaid technical solution, by providing the relationship between the size h1 of the first protective member 51 and the size h2 of the connection portion 41 in the thickness direction of the first wall 30 within the above range, it is possible to further improve the protective effect of the first protective member 51.

For example, the value of h1-h2 may be, but is not limited to, 1mm, 1.5mm, 2mm, 3mm.

Continuing to refer to Fig. 9, in some embodiments, the first protective member 51 has a wall thickness d1≥0.5mm.

The wall thickness of the first protective member 51 can be understood as the thickness of the first protective member 51 in the direction towards the center point of the electrode terminal 31 along the edge of the electrode terminal 31. By providing the wall thickness d1 of the first protective member 51 within the above range, it is possible to further improve the protective effect of the first protective member 51.

For example, the wall thickness d1 of the first protective member 51 may be, but is not limited to, 0.5mm, 1mm, 2mm, 3mm.

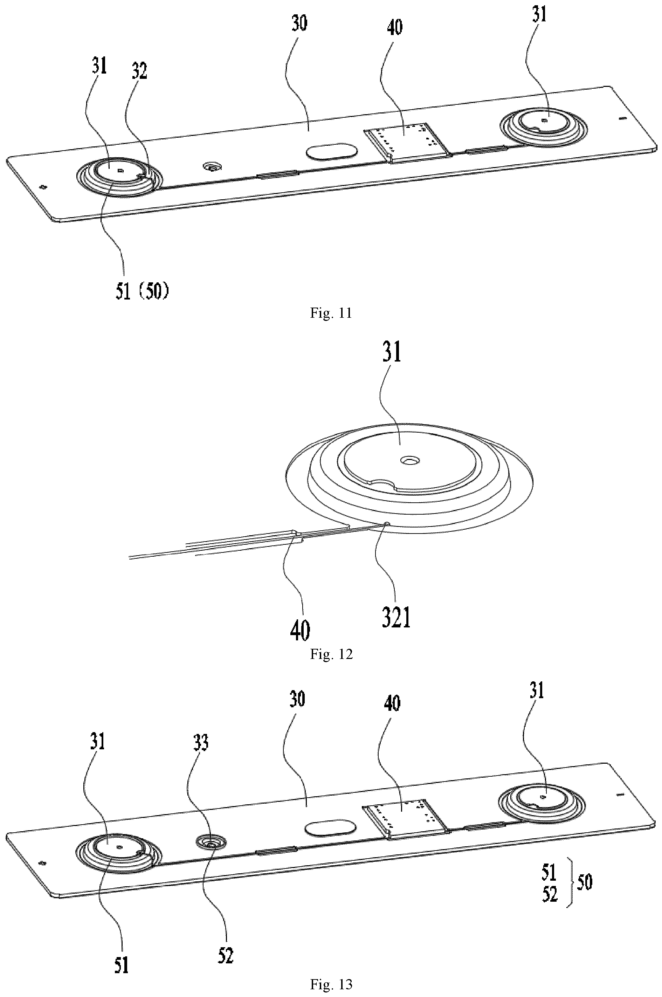

Fig. 11 is a schematic structural view of a first wall of another battery cell provided by some embodiments of the application.

As shown in Fig. 11, in some embodiments, the battery cell further includes an insulation member 32, and the insulation member 32 is used to insulate the electrode terminal 31 from the first wall 30. The insulation member 32 has a protrusion protruding from the side surface of the electrode terminal 31 away from the first wall 30, and the protrusion is configured as the first protective member 51.

The arrangement position of the insulation member 32 is not limited. For example, the insulation member 32 may be arranged on the side of the first wall 30 away from the accommodation cavity, or the insulation member 32 may also be arranged on the side of the first wall 30 facing towards the accommodation cavity, or the insulation member 32 may also be arranged on both the side of the first wall 30 away from the accommodation cavity and the side of the first wall 30 facing towards the accommodation cavity.

For example, in the embodiments of the application, the inventive concept is illustrated taking that the insulation member 32 is arranged on the side of the first wall 30 away from the accommodation cavity as an example. The insulation member 32 is arranged to encircle the portion of the electrode terminal 31 protruding from the side surface of the first wall 30 away from the accommodation cavity. The insulation member 32 and the electrode terminal 31 abut with each other, and the insulation member 32 is used to insulate the electrode terminal 31 from the first wall 30. The detection assembly 40 is arranged on the side surface of the first wall 30 away from the accommodation cavity.

The insulation member 32 has a protrusion protruding from the side surface of the electrode terminal 31 away from the first wall 30, and the protrusion is configured as the first protective member 51 to separate the connection portion from the central region of the side surface of the electrode terminal 31 away from the first wall 30.

By providing a protrusion on the insulation member 32 to serve as the first protective member 51, the insulation member 32 is integrally formed into a protrusion through stamping technology, resulting in an integrated structure between the protrusion and the insulation member 32. On the one hand, it is convenient to apply the protrusion of the embodiment to the design of the existing insulation member 32, without the need for excessive modifications to the design of the existing insulation member 32; on the other hand, the insulation member 32 forms a protrusion through stamping technology, which is simple to manufacture and does not require additional materials to form the protrusion.

Fig. 12 is a schematic structural partial enlarged view at an insulation member of a battery cell provided by some embodiments of the application.

As shown in Figs. 11 to 12, in some embodiments, the insulation member 32 is provided with a through hole 321, and the detection assembly 40 is connected to the electrode terminal 31 by the through hole 321.

Specifically, the insulation member 32 is provided with a through hole 321 on the side close to the detection member, and the detection member is electrically connected to the electrode terminal 31 located inside the insulation member 32 through the through hole 321.

In the aforesaid technical solution, the detection assembly 40 is connected to the electrode terminal 31 located inside the insulation member 32 through the through hole 321, and the connection portion 41 between the detection assembly 40 and the electrode terminal 31 is located inside the insulation member 32, reducing the risk of damage to the connection portion 41 between the detection member and the electrode terminal 31 due to exposure to the external environment.

Fig. 13 is a schematic structural view of a first wall of yet another battery cell provided by some embodiments of the application

As shown in Fig. 13, in some embodiments, the first wall 30 is provided with a liquid injection hole 33, the protective assembly 50 includes a second protective member 52, and the second protective member 52 protrudes from a side surface of the first wall 30 away from the accommodation cavity and surrounds the liquid injection hole 33.

The liquid injection hole 33 penetrates through the first wall 30, and the operator can inject electrolyte solution into the battery cell 7 through the liquid injection hole 33. During the process of injecting liquid into the battery cell 7, the electrolyte solution may overflow outside the liquid injection hole 33 and flow through the surface of the first wall 30 to the detection assembly 40, which can easily cause damage to the detection assembly 40.

In the embodiments of the application, the inventive concept is illustrated taking that the detection assembly 40 is arranged on the side of the first wall 30 away from the accommodation cavity as an example. The second protective member 52 protrudes from the side surface of the first wall 30 away from the accommodation cavity, and the boss has a certain height in the thickness direction of the first wall 30. The detection assembly 40 and the second protective member 52 are located on the same side of the first wall 30. The second protective member 52 is arranged to surround the liquid injection hole 33 to form a boss structure surrounding the liquid injection hole 33. The orthographic projection of the second protective member 52 in the thickness direction of the first wall 30 may be circular, square, or triangular and the like. The application does not limit the shape of the orthographic projection of the second protective member 52 in the thickness direction of the first wall 30, and the shape can be selected according to the actual situation. When the operator injects electrolyte solution into the battery cell 7 through the liquid injection hole 33, the second protective member 52 can reduce the risk of electrolyte solution overflow.

By providing the second protective member 52 around the liquid injection hole 33, the risk of the electrolyte solution overflow causing damage to the detection assembly 40 can be reduced, further improving the protective effect of the protection assembly 50.

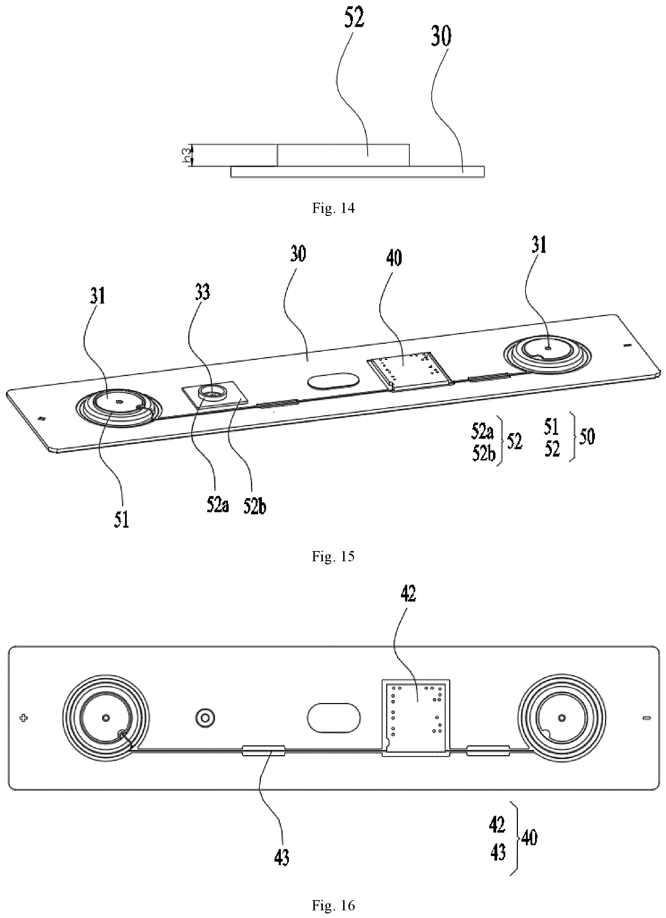

Fig. 14 is a schematic structural partial enlarged view at a second protective member of a battery cell provided by some embodiments of the application.

As shown in Fig. 14, in some embodiments, in the thickness direction of the first wall 30, the size of the second protective member 52 is h3≥1mm.

In the thickness direction of the first wall 30, the size of the second protective member 52 can be understood as the protrusion height of the second protective member 52 protruding from the side surface of the first wall 30 away from the accommodation cavity. By providing the size h3 of the second protective member 52 within the above range, it is possible to further improve the protective effect of the second protective member 52.

For example, in the thickness direction of the first wall 30, the size h3 of the second protective member 52 may be, but is not limited to, 1.0mm, 1.5mm, 2.0mm, 3mm.

Fig. 15 is a schematic structural view of a first wall of still yet another battery cell provided by some embodiments of the application

As shown in Fig. 15, in some embodiments, the second protective member 52 includes a blocking portion 52a and an adsorption portion 52b, and the adsorption portion 52b is arranged on the side of the blocking portion 52a away from the liquid injection hole 33.

Optionally, the blocking portion 52a protrudes from the side surface of the first wall 30 away from the accommodation cavity and surrounds the liquid injection hole 33. The adsorption portion 52b may be, but not limited to, made of materials with liquid adsorption function, such as polyurethane, acrylic acid, and the like. The orthographic projection of the adsorption portion 52b in the thickness direction of the first wall 30 may be circular, square, or triangular and the like. The application does not limit the shape of the orthographic projection of the adsorption portion 52b in the thickness direction of the first wall 30, and the shape can be selected according to the actual situation.

When the operator injects electrolyte solution into the battery cell 7 through the liquid injection hole 33, even though the protrusion may have a certain blocking effect on the electrolyte solution, there is still a risk of electrolyte solution splashing out of the blocking portion 52a. With the adsorption portion 52b provided on the side of the blocking portion 52a away from the liquid injection hole 33, when the electrolyte solution splashes out of the blocking portion 52a, the adsorption portion 52b can adsorb the splashed electrolyte solution.

In the aforesaid technical solution, the second protective member 52 includes a blocking portion 52a and an adsorption portion 52b located on the side of the blocking portion 52a away from the injection hole 33. While the blocking portion 52a can reduce electrolyte solution overflow, the adsorption portion 52b can further adsorb the electrolyte solution splashed out in a few cases, further enhancing the protective effect of the second protective member 52.

In some embodiments, the adsorption portion 52b is distribute surrounding the blocking portion 52a in a circumferential direction.

For example, the adsorption portion 52b is distributed in an annular segment in the circumferential direction of the blocking portion 52a, allowing for the adsorption of electrolyte solution splashed out in a few cases with minimal use of materials, effectively reducing costs. The adsorption portion 52b is distributed in an annular shape in the circumferential direction of the blocking portion 52a, and is arranged around the entire circumference of the blocking portion 52a, which can increase the adsorption range of the adsorption portion 52b and effectively improve the adsorption effect of the adsorption portion 52b.

In some embodiments, the second protective member 52 and the first wall 30 are of an integrally formed structure.

The first wall 30 is integrated with the second protective member 52 through stamping technology, so that the second protective member 52 and the first wall 30 form an integrated structure. On the one hand, there is no need to make significant changes to the design of the housing 20 of the existing battery cell 7; on the other hand, the first wall 30 forms a second protective member 52 through stamping technology, which is simple in production process and does not require additional materials to form a second protective member 52.

In some embodiments, the housing 20 includes a housing body and an end cap, the housing body has an opening, and the end cap is used to cap the opening. The end cap is configured as the first wall 30 of the housing 20.

The housing body may have various shapes such as a cylinder, a cuboid and the like. The shape of the housing body may be determined according to a specific shape of the electrode assembly. For example, if the electrode assembly is of a cylindrical structure, the housing may be selected to be cylindrical, and if the electrode assembly is of a cuboid structure, the housing may be selected to be cuboid.

The end cap may have various structures, such as a plate-like structure, a hollow structure with one end open and the like. For example, the housing body is of a cuboid structure, the end cap is of a plate-like structure, and the end cap is capped to the opening of the top of the housing body. The end cap may be made of an insulating material (for example, plastic) or a conductive material (for example, metal).

In the embodiments of the application, the first wall 30 may be the end cap. Optionally, the detection assembly 40 may be arranged on a side of the end cap away from the accommodation cavity, or may also be arranged on a side of the end cap facing towards the accommodation cavity. The connection type between the detection assembly 40 and the end cap may be, but is not limited to, welding, clamping, or adhering.

In some embodiments, the material of the protective assembly 50 is an insulation-heat barrier material.

The battery cell 7 will continuously charge and discharge during use, generating a significant amount of heat during the charging and discharging process. The protective assembly 50 and the detection assembly 40 are prone to contact. For example, the insulation-heat barrier material may be polytetrafluoroethylene, polyphenylene sulfide, polyether ether ketone, polyphenylene ester and the like. The application does not impose specific material limitations and can be selected based on actual circumstances.

By using an insulation-heat barrier material to produce the protective assembly 50, the impact of heat generated by the battery cell 7 during use on the protective assembly 50 can be reduced, and the service life of the protective assembly 50 can be improved. At the same time, it can avoid interference between the protective assembly 50 and the detection assembly 40, which will affect the normal use of the detection assembly 40.

Fig. 16 is a schematic structural view of a first wall of still yet another battery cell provided by some embodiments of the application

As shown in Fig. 16, in some embodiments, the detection assembly 40 includes a sensing member 42 and a connector 43 connected to each other, and the connector 43 is used to transmit an electrical signal to the sensing member 42.

For example, the sensing member 42 is used to detect an operation state of the battery cell. Here, the sensing member 42 includes, but is not limited to, a temperature sensor, a pressure sensor and the like. The connector 43 is used to transmit an electrical signal to the sensing member 42, and the sensing member 42 is electrically connected to the battery cell by the connector 43. Here, the connector 43 includes, but is not limited to, an optical fiber. By using the optical fiber as the connector 43, it is possible to improve the signal transmission speed.

According to some embodiments of the application, the application further provides a battery including the battery cell in the aforesaid solution.

According to some embodiments of the application, the application further provides an electric device including the battery cell of the above solutions used to provide electrical energy.

In order to better understand the battery cell provided by the embodiments of the application, based on the same inventive concept, the embodiments of the aforementioned battery cell in practical applications are provided for explanation.

The embodiments of the application provide a battery cell 7 including a housing body, an electrode assembly, an end cap, an electrode terminal 31, an insulation member 32, a detection assembly 40, a protective assembly 50 and a liquid injection hole 33. Among them, the housing body has an opening and an accommodation cavity, the electrode assembly is accommodated in the accommodation cavity, and the end cap is capped to the opening of the housing body.

The electrode terminal 31 protrudes from the side surface of the end cap away from the accommodation cavity, and the electrode terminal 31 is electrically connected to the electrode tab of the electrode assembly. The insulation member 32 is used to insulate the electrode terminal 31 from the end cap.

The detection assembly 40 includes a sensing member 42 and a connector 43 connected to each other, and the connector 43 is used to transmit an electrical signal to the sensing member 42. The detection assembly 40 is arranged on the side surface of the end cap away from the accommodation cavity, and the detection assembly 40 is electrically connected to the electrode terminal 31 and forms a connection portion 41 on the electrode terminal 31.

The protective assembly 50 includes a first protective member 51 and a second protective member 52. The first protective member 51 protrudes from the side surface of the electrode terminal 31 away from the end cap, and the first protective member 51 is used to separate the side surface of the electrode terminal 31 away from the end cap from the connection portion 41. The first protective member 51 is distributed in an annular segment or in an annular shape in a circumferential direction of the electrode terminal 31. The first protective member 51 includes a body portion 51a and an avoidance portion 51b. The avoidance portion 51b is formed by the body portion 51a being recessed towards the center point of the electrode terminal 31 so as to avoid the connection portion 41. In the thickness direction of the end cap, the first protective member 51 has a size h1, the connection portion 41 has a size h2, and h1-h2≥1mm.

The end cap is provided with a liquid injection hole 33, and the second protective member 52 protrudes from the side surface of the end cap away from the accommodation cavity and surrounds the liquid injection hole 33. In the thickness direction of the first wall 30, the second protective member 52 has a size h3≥1mm.

In the aforesaid technical solution, the detection assembly 40 can perform a real-time detection of the operation state of the battery cell 7, where the operation state of the battery cell 7 includes, but is not limited to, voltage, temperature, and other related data. By providing a detection assembly 40 on the battery cell 7, it is convenient to control the operation state of the battery cell 7 in real time. Abnormal parameters during operation of the battery cell 7 can be quickly warned, enabling corresponding safety agencies or personnel to respond in a timely manner, thereby improving safety and reliability of the battery cell 7.

The protective assembly 50 is used to protect the detection assembly 40, so that a risk of damage to the detection assembly 40 during the use of the battery cell 7 can be reduced.

By providing the first protective member 51 on the side surface of the electrode terminal 31 away from the first wall 30, and separating the connection portion 41 from a central region of the side surface of the electrode terminal 31 away from the first wall 30, it is possible to reduce a risk of damage to the detection assembly 40 during formation process of the battery cell 7.

By providing the second protective member 52 around the liquid injection hole 33, the risk of the electrolyte solution overflow causing damage to the detection assembly 40 can be reduced, further improving the protective effect of the protection assembly 50.

It should be noted that, in the case of no contradiction, the embodiments in the application and the features in the embodiments may be combined with each other.

At last, it should be appreciated that the above embodiments are only used to illustrate the technical solution of the application but not to limit the same. Although the application is described in detail with reference to the above embodiments, a person of ordinary skill in the art is to understand that it is still possible to modify the technical solution described in the above embodiments or equivalently replace some or all of the technical features thereof. The modifications and replacements shall not render the substance of the corresponding technical solution deviate from the spirit and scope of the technical solution in the various embodiments of the application, all of which are to be covered by the scope of the claims and description of the application. In particular, the various technical features mentioned in various embodiments can be combined in any way. The application is not limited to the specific embodiments disclosed herein, but includes all the technical solutions which fall into the scope of the claims.

## Claims

1. A battery cell, **characterized in that** the battery cell comprises:
a housing comprising an accommodation cavity;
an electrode assembly accommodated in the accommodation cavity;
a detection assembly connected to the housing and for detecting an operation state of the battery cell;
a protective assembly protruding from the housing and arranged on a same side as the detection assembly so as to protect the detection assembly.

2. The battery cell according to claim 1, **characterized in that** the housing comprises a first wall, and the detection assembly is connected to the first wall.

3. The battery cell according to claim 2, **characterized in that** the detection assembly is located on a side of the first wall away from the accommodation cavity.

4. The battery cell according to claim 3, **characterized in that** the housing comprises an electrode terminal, the electrode terminal protrudes from a side surface of the first wall away from the accommodation cavity, the electrode terminal is electrically connected to an electrode tab of the electrode assembly, and the detection assembly is electrically connected to the electrode terminal and forms a connection portion on the electrode terminal.

5. The battery cell according to claim 4, **characterized in that** the protective assembly comprises a first protective member, the first protective member protrudes from a side surface of the electrode terminal away from the first wall, and the first protective member is used to separate the side surface of the electrode terminal away from the first wall from the connection portion.

6. The battery cell according to claim 5, **characterized in that** the first protective member is distributed in an annular segment or in an annular shape in a circumferential direction of the electrode terminal.

7. The battery cell according to claim 5, **characterized in that** the first protective member comprises a body portion and an avoidance portion, and the avoidance portion is formed by the body portion being recessed towards a center point of the electrode terminal so as to avoid the connection portion.

8. The battery cell according to claim 5, **characterized in that** in a thickness direction of the first wall, the first protective member has a size h1, the connection portion has a size h2, and h1>h2.

9. The battery cell according to claim 8, **characterized in that** h1 and h2 satisfy a relationship of: h1-h2≥1mm.

10. The battery cell according to claim 5, **characterized in that** the first protective member has a wall thickness d1≥0.5mm.

11. The battery cell according to claim 5, **characterized in that** the battery cell further comprises an insulation member for insulating the electrode terminal from the first wall;
the insulation member has a protrusion protruding from the side surface of the electrode terminal away from the first wall, and the protrusion is configured as the first protective member.

12. The battery cell according to claim 11, **characterized in that** the protrusion and the insulation member are of an integrally formed structure.

13. The battery cell according to claim 11, **characterized in that** the insulation member is provided with a through hole, and the detection assembly is connected to the electrode terminal through the through hole.

14. The battery cell according to claim 3, **characterized in that** the first wall is provided with a liquid injection hole, the protective assembly comprises a second protective member, and the second protective member protrudes from a side surface of the first wall away from the accommodation cavity and surrounds the liquid injection hole.

15. The battery cell according to claim 14, **characterized in that** in a thickness direction of the first wall, the second protective member has a size h3≥1mm.

16. The battery cell according to claim 14, **characterized in that** the second protective member comprises a blocking portion and an adsorption portion, and the adsorption portion is arranged on a side of the blocking portion away from the liquid injection hole.

17. The battery cell according to claim 16, **characterized in that** the adsorption portion is distributed surrounding the blocking portion in a circumferential direction.

18. The battery cell according to claim 14, **characterized in that** the second protective member and the first wall are of an integrally formed structure.

19. The battery cell according to claim 2, **characterized in that** the housing comprises a housing body and an end cap, the housing body comprises an opening, and the end cap is used to cap the opening;
the end cap is configured as the first wall of the housing.

20. The battery cell according to claim 1, **characterized in that** a material of the protective assembly is an insulation-heat barrier material.

21. The battery cell according to any of claims 1-20, **characterized in that** the detection assembly comprises a sensing member and a connector connected to each other, and the connector is used to transmit an electrical signal to the sensing member.

22. The battery cell according to claim 21, **characterized in that** the connector comprises an optical fiber.

23. A battery, **characterized in that** the battery comprises the battery cell according to any of claims 1-22.

24. An electric device, **characterized in that** the electric device comprises the battery cell according to any of claims 1-22 used to provide electrical energy.
